(19) Europäisches Patentamt
European Patent Office
Office européen des brevets

(11) **EP 2 797 100 A1**

(12) **EUROPEAN PATENT APPLICATION**

(43) Date of publication:
**29.10.2014 Bulletin 2014/44**

(51) Int Cl.:
***H01J 37/26*** ^(2006.01)

(21) Application number: **13165356.0**

(22) Date of filing: **25.04.2013**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(71) Applicants:
• **FEI COMPANY**
**Hillsboro, Oregon 97124-5793 (US)**
• **Max-Planck-Gesellschaft zur Förderung der Wissenschaften e.V.**
**80539 München (DE)**

(72) Inventors:
• **Buijsse, Bart**
**5646 JE Eindhoven (NL)**
• **Danev, Radostin**
**81375 München (DE)**

(74) Representative: **Bakker, Hendrik**
**FEI Company**
**Patent Department**
**P.O. Box 1745**
**5602 BS Eindhoven (NL)**

(54) **Method of using a phase plate in a transmission electron microscope**

(57)     The invention relates to a method of using a phase plate (118) in a transmission electron microscope (100), the phase plate comprising a thin film, the method comprising: introducing the phase plate in the transmission electron microscope;

preparing the phase plate by irradiating the film with a focused electron beam;

introducing a sample (108) in the transmission electron microscope; and forming an image of the sample using the prepared phase plate,

characterized in that

preparing the phase plate involves locally building up a vacuum potential resulting from a change in the electronic structure of the thin film by irradiating the phase plate with a focused beam of electrons, the vacuum potential leading to an absolute phase shift $|\varphi|$ with a smaller value than at the non-irradiated thin film.

    Preferably the phase plate is heated to avoid contamination. The phase shift achieved with this phase plate can be tuned by varying the diameter of the irradiated spot.

**FIG. 1**

EP 2 797 100 A1

## Description

The invention relates to a method of using a phase plate in a transmission electron microscope, the phase plate comprising a thin film, the method comprising:

> introducing the phase plate in the transmission electron microscope;
> preparing the phase plate by irradiating the film with a focused electron beam;
> introducing a sample in the transmission electron microscope; and
> forming an image of a sample using the prepared phase plate.

This method is known from "Principles and Techniques of Electron Microscopy, Vol. 3: Biological applications", Ed. M.A. Hayat, ISBN- 0-442-25674-4, Chapter 4: In-focus phase contrast electron microscopy, H.M. Johnson, Electron Optics Laboratory, Dept. of Biophysics, Roswell Park Memorial Institute, Buffalo, N.Y., USA, specifically page 174-176

In a Transmission Electron Microscope (TEM) a sample is imaged by passing a beam of energetic electrons with a selectable energy of, for example, between 40 keV and 400 keV, through the sample. For so-called weak-phase samples, such as biological samples, most electrons pass through the sample while some electrons are elastically or inelastically scattered, the elastically scattered electrons forming diffracted beams. The image is formed by interference of the elastically scattered and unscattered electrons (diffracted and undiffracted beams).

A problem arises in that the Contrast Transfer Function (CTF) for low spatial frequencies in the image is zero or close to zero, resulting in low visibility of large objects/structures. This is caused by the fact that a camera or fluorescent screen at the image plane is sensitive to intensity variations, but not to phase variations of the impinging electron beam.

A solution to this is the use of a phase plate, the phase plate introducing a phase difference between the diffracted beams and the undiffracted beam. There are two main types of phase plates: the so-called Zernike phase plate leaves the undiffracted beam unchanged, and causes a phase shift of the diffracted beams, while the so-called Boersch phase plate shifts the undiffracted beam while leaving the diffracted beams unchanged.

The introduction of the phase difference by the phase plate changes the sine-like behavior of the CTF to a cosine-like behavior, and thus a maximum contrast for low spatial frequencies. For a more thorough description of phase plates and other contrast enhancing devices see "Phase Contrast Enhancement with Phase Plates in Biological Electron Microscopy", K. Nagayama et al., Microscopy Today, Vol. 18 No. 4 (July 2010), pp. 10-13, further referred to as Nagayama [-2-].

A problem of both Boersch phase plates and Zernike phase plates is that they require microscopic holes (typically less than 1 $\mu$m) and a centering accuracy which is even an order of magnitude better than the hole size.

Another type of phase plate is the phase plate, as first described by Johnson [-1-]. The phase plate described by Johnson is formed by a contamination spot on a continuous carbon film. This spot is formed using the electron beam in high current mode. The contamination spot modifies the thickness of the film, resulting in a thicker part. This film can then, at lower current, be used as a phase plate, where the undiffracted electrons, passing through the thick spot, experience a larger (negative) phase shift than the diffracted electrons passing through the non-contaminated (or less-contaminated) film. The effect of such a phase plate thus resembles the effect of Zernike phase plate, but with the difference that this phase plate gives a negative phase contrast.

An advantage of such a phase plate is that it is self-building and thus centered.

A disadvantage of this phase plate is that the build-up of contaminants is difficult to control, thus hampering practical use of the device

It is noted that electrons travelling through a thin film experience a negative phase shift relative to electrons travelling the same distance in vacuum, as the material has a positive inner potential, thus accelerating the electrons inside the material. Electrons travelling in a material are thus advanced with respect to electrons that do not travel through the material, resulting in said negative phase shift. As this is often misunderstood, often the absolute phase shift $|\varphi|$ is referred to.

Another such phase plate is known from US patent application No. US 2011/0174971A1, describing a film exposed to an electron beam, resulting in positive charging (due to secondary electron emission) and/or contamination (or the charging of contamination).

Inventors found as a disadvantage of this phase plate that keeping the charging constant is quite difficult, and results in hard to control operation.

There is a need for a reliable, self-centered phase plate.

The invention intends to provide a solution.

To that end the method of the invention is **characterized in that** preparing the phase plate involves locally building up a vacuum potential resulting from a change in the electronic structure of the thin film by irradiating the phase plate with a focused beam of electrons, the vacuum potential leading to a phase shift that is less than at the non-irradiated thin film.

Inventors found that by irradiating the thin film with electrons in an environment where contamination was absent, or negligible, a change in imaging could be observed resulting in a positive phase contrast (contrary to the negative phase contrast observed by Johnson). Such a contamination-free condition can simply be generated by heating the film to a temperature above approximately 200 °C. As this is a positive phase contrast, this is easily identified to differ from the positive phase contrast occurring by contamination or positive charging, and must concern another principle.

Inventors bring forward that this positive phase contrast is based on a change of the electronic structure of the material.

Each material has a chemical potential $\mu$ that depends not only on the materials composition, but also on its phase, crystallographic properties, etc. The chemical potential is related to the electrochemical potential according to

$$\bar{\mu} = \mu + \psi,$$

with $\bar{\mu}$ the electrochemical potential, $\mu$ the chemical potential and $\psi$ the Galvani potential. When two conducting materials are electrically connected, the electrochemical potential $\bar{\mu}$ is necessarily equalized, and any difference in chemical potential thus results in a different Galvani potential.

As is known from, for example semiconductor materials, irradiation of a material with a beam of electrons results in bond-breaking, creating electron trapping centra that may act as p-type dopants. This may result in a material with a lower chemical potential, where electrons flow toward the p-doped area and create a negative potential.

It is therefore concluded that the irradiation with the beam locally modifies the material, possibly by bond-breaking and/or the corresponding formation of p-type dopant positions.

Inventors found that the effect is dependent on the amount of electrons deposited on the thin film, and on the size of spot exposed: a large dose results in a large phase shift, and a large spot irradiated with an identical current density results in a large phase shift. However, the phase shift is not a linear function of the deposited dose, but increases up to some maximum value that corresponds with a steady state that establishes itself.

Inventors also found that the effect returned to its normal state, and a phase plate according to the invention using a thin film of amorphous carbon must be prepared anew with the electron beam after approximately one day.

It is noted that the effect on which this type of phase plate relies is explained in terms of the Galvani effect, but is in more general terms attributed to any vacuum potential outside of the film that arises due to a change in the internal electronic structure of the film.

It is noted that the current and current density of the spots formed by diffracted electrons is in normal use insufficient to cause a noticeable change in vacuum potential.

Preferably the phase plate is operated in a heated condition, thereby avoiding contamination. The heating can be achieved by e.g. laser heating of the thin film, or by heating of a part of a holder holding the thin film (typically an aperture mechanism), for example by ohmic heating.

Should the phase plate deteriorate at the position used, it is well possible to use another part of the thin film, prepare that part by irradiating the new position with electrons.

The thin film may further show markers, for example to help aligning the transmission electron microscope, for example to accurately setting up of beam shift pivot points and finding the in-plane condition.

Preferably the thin film is a carbon film, more specifically an amorphous thin film, although also the use of SiN, SiB, SiC and Si films is known.

The invention is now explained using figures, in which identical numerals refer to corresponding features. To that end:

Figure 1 schematically shows a TEM 100 equipped with a phase plate,
Figure 2 schematically shows the thin film 200 that is irradiated in an area surrounding the axis of the electron microscope,
Figure 3 schematically shows the potential of the thin film after irradiation, and
Figure 4 schematically shows the phase shift induced as a function of irradiation time.

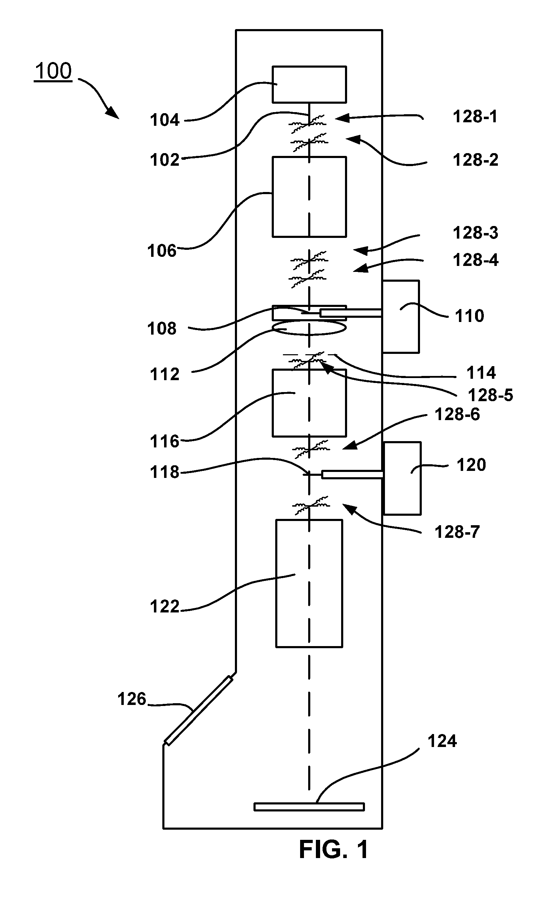

Figure 1 schematically shows a TEM 100 equipped with a phase plate.

Figure 1 shows a particle source 104 producing a beam of particles, such as electrons, along optical axis 102. The particles have a selectable energy of typically between 80 - 300 keV, although higher energies, e.g. 400 keV - 1 MeV, or lower energies, e.g. 50 keV, may be used. The beam of particles is manipulated by condenser system 106 to form a parallel beam impinging on a sample 108, the sample positioned with a sample holder 110. The sample holder can position the sample with respect to the optical axis and may shift the sample in the plane perpendicular to the optical axis and tilt the sample with respect to said axis. Objective lens 112 forms a magnified image of the sample. The objective lens is followed by a magnifying system 116, e.g. a doublet of lenses, forming an enlarged image of the back-focal plane 114 of the objective lens. A phase plate 118 is placed in the enlarged image of the back-focal plane of the objective lens, this conjugated plane positioned between the magnifying system and a projection system 122. The phase plate is positioned with a manipulator 120, allowing the phase plate to be centered round the optical axis. The projection system forms a magnified image of the sample on a detector 124, thereby revealing sample details of e.g. 0.1 nm. The detector may take the form of a fluorescent screen, or e.g. a CCD or CMOS camera. In the case of e.g. a fluorescent screen the screen can be viewed via the glass window 126.

To align the optical components on the axis the TEM comprises a large number of deflectors, schematically shown as 128-1..128-7, although other deflectors on other places may be included.

It is noted that the phase plate may also be positioned in the back-focal plane itself, in which case the magnifying system 116 is superfluous.

The phase plate is normally formed as a thin film surrounded by a holder structure, for example a platinum aperture as commonly used in electron microscopy. Forming the phase plate with such an aperture has as an advantage that a standard aperture holder can be used to hold and position the phase plate. It is noted that heated aperture holders are known, the heating used to avoid contamination.

By now exposing the thin film to a large dose of energetic electrons, for example 200 keV electrons, knock-on damage occurs, resulting in electron traps. This may be thought of as p-type dopants. The resulting change in electronic structure, here referred to as a change in Galvani potential, causes a local change in external potential.

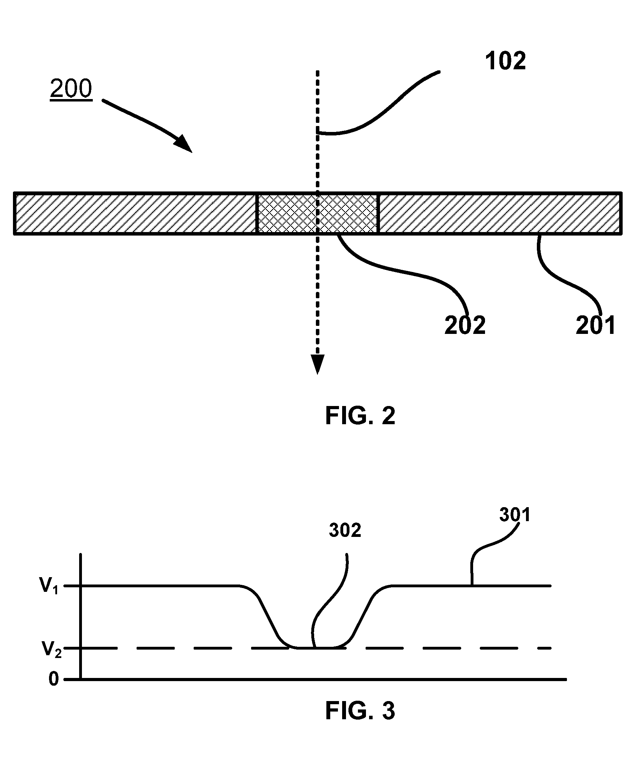

Figure 2 schematically shows the thin film 200 that is irradiated in an area surrounding the axis 102 of the electron microscope. As a result the electronic structure of the area 202 is changed, while that of the non-irradiated area 201 is unchanged.

Figure 3 schematically shows the potential of the thin film after irradiation. Removed from the axis the potential equals the chemical potential, but the irradiated area has an added (negative) electronic potential.

Undiffracted electrons, travelling towards and through the irradiated part 202 of the thin film, experience less acceleration than diffracted electrons travelling through other parts of the thin film, as $V_2$ is less than $V_1$. This causes a positive phase contrast when the beams interfere in the image plane to form an image.

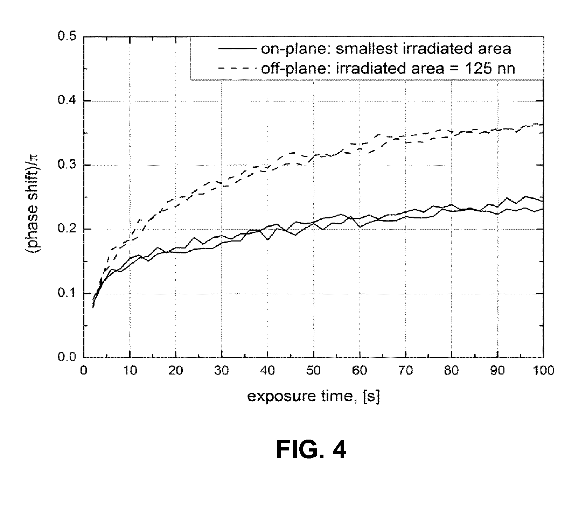

Figure 4 schematically shows the phase shift induced as a function of irradiation time.

Inventors found that the phase shift is not a linear function of the dose deposited on the thin film. This implies that there is an upper limit to the Galvani potential induced by the electron beam. Inventors also found that when a larger area (dotted line, irradiated area with a diameter of 125 nm) was irradiated using an identical total beam current as a small area (solid line), the large area resulted in a large phase shift than the small area. This can be explained as follows: First, assume that a maximum vacuum potential can be induced. Then compare two electron beams, one passing through the irradiated part and one far removed from this part, and define z along the electron-optical axis 102. The integral $\int_{-\infty}^{\infty}$ $V(z)dz$ (more accurately from the sample plane to the image plane) differs due to the vacuum potential. When the spot that is irradiated grows, the difference between the two integrals scales with the size of the spot (assuming the same vacuum potential). Therefore the phase shift can be tuned by controlling the size of the spot that is irradiated during the preparation of the phase plate. The curves shown in figure 4 are obtained at identical beam current. It will be clear to the skilled person that a higher beam current, as is achievable using a larger spot size, results in a quicker settling time.

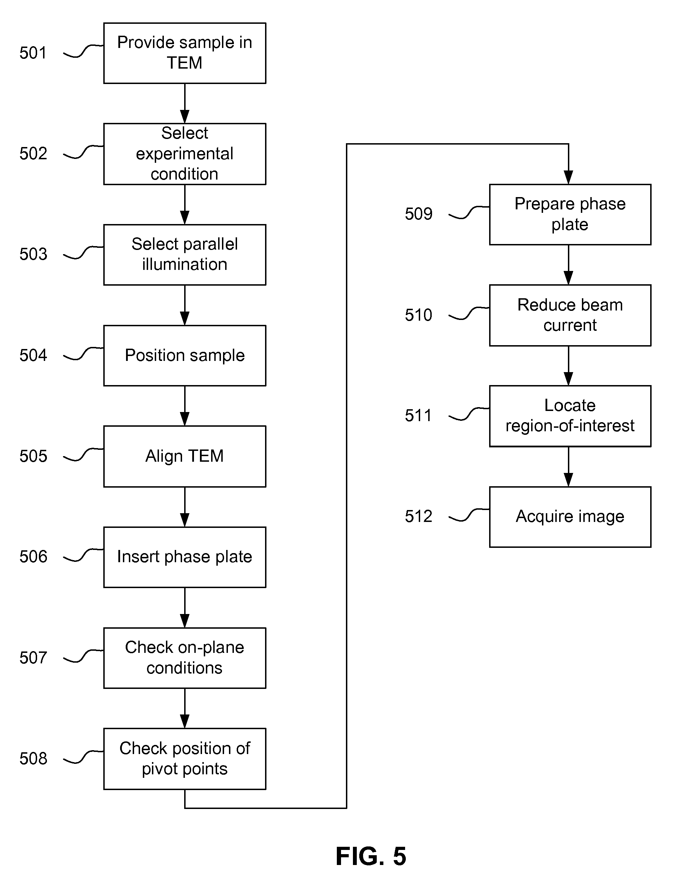

Figure 5 schematically shows a workflow for operating a transmission electron microscope equipped with a phase plate according to the invention.

In step 501 a sample is provided in the transmission electron microscope (TEM).

In step 502 the experiments' conditions are selected, the conditions including electron beam energy, spot size condenser aperture (implying the selection of a beam current), magnification, etc.

In step 503 the condenser is set to illuminate the sample with a parallel beam of electrons.

In step 504 the sample is positioned to eucentric height (where the sample can be tilted without height variations) and focus is set (so that parallel beams in the sample plane result in focused beams in the back-focal plane of the objective lens).

In step 505 standard microscope alignments are performed.

In step 506 the phase plate is inserted in the beam path. The phase plate is inserted only now to minimize unwanted exposure (irradiation) of the phase plate.

In optional step 507 on-plane conditions (indicating whether the phase plate is exactly in the back-focal plane or slightly removed from it) are checked, for example using features on the phase plate, and the condenser lens is adjusted if necessary. As discussed earlier, by working slightly off-plane the size of the irradiated area can be tuned/selected. It is noted that the phase plate need not be in the back-focal plane, but may reside in a plane conjugated to it.

In step 508 pivot point settings of the beam are checked and image shift, using e.g. the features on the phase plate, ensuring that a tilt of the beam entering the objective lens ideally results in a pure shift in the sample plane and a pure tilt in the back-focal plane of the objective lens (and thus the plane where the phase plate resides).

In step 509 the phase plate is prepared by keeping the beam on a clean area of the phase plate for an appropriate amount of time (for example based on earlier experiments), the amount of time depending on beam intensity (beam current), beam size and phase plate material. Typically this amounts to 10 - 100 seconds of irradiation time.

In step 510 the beam current is reduced to imaging conditions as are normal for imaging samples, after which a region of interest is located on the sample.

In step 511 an image is acquired.

As mentioned earlier, the phase plate can be a heated phase plate (with a regulated temperature of, for example, between 100 °C and 400 °C) to avoid contamination. It that case step 501 should also include thermal stabilization of said temperature so that drift of the phase plate becomes negligible.

The last steps 510 and 511 can be repeated until sufficient data is gathered from the sample. Refocusing, tilting and (mechanically) shifting the sample may be required.

**Non-patent literature**

[-1-] "Principles and Techniques of Electron Microscopy, Vol. 3: Biological applications", Ed. M.A. Hayat, ISBN- 0-442-25674-4, Chapter 4: In-focus phase contrast electron microscopy, H.M. Johnson, Electron Optics Laboratory, Dept. of Biophysics, Roswell Park Memorial Institute, Buffalo, N.Y., USA, specifically page 174-176

[-2-] "Phase Contrast Enhancement with Phase Plates in Biological Electron Microscopy", K. Nagayama et al., Microscopy Today, Vol. 18 No. 4 (July 2010), pp. 10-13.

**Claims**

1. A method of using a phase plate (118) in a transmission electron microscope (100), the phase plate comprising a thin film, the method comprising:

   introducing the phase plate in the transmission electron microscope;
   preparing the phase plate by irradiating the film with a focused electron beam;
   introducing a sample (108) in the transmission electron microscope; and
   forming an image of the sample using the prepared phase plate,
   **characterized in that**
   preparing the phase plate involves locally building up a vacuum potential resulting from a change in the electronic structure of the thin film by irradiating the phase plate with a focused beam of electrons, the vacuum potential leading to an absolute phase shift $|\varphi|$ with a smaller value than at the non-irradiated thin film.

2. The method of claim 1 in which the phase plate is heated to avoid contamination.

3. The method of any of the preceding claims in which the phase plate induces a positive phase contrast.

4. The method of any of the preceding claims in which, after irradiating the phase plate with a beam comprising scattered and non-scattered electrons, the mutual position of phase plate and beam is changed, the phase plate is prepared anew, after which the phase plate is again irradiated with a beam comprising scattered and non-scattered electrons.

5. The method of any of the preceding claims in which the thin film comprises markers and/or holes used to align the transmission electron microscope.

6. The method of any of the preceding claims in which the film comprises carbon, more specifically amorphous carbon.

7. The method of any of the preceding claims in which imaging the sample includes irradiating the sample with a parallel beam of electrons.

8. The method of any of the preceding claims in which during locally building up the vacuum potential the diameter of the focus of the focused beam is controlled to give a predetermined phase shift.

**FIG. 1**

**200**

**102**

**202**

**201**

**FIG. 2**

**302**

**301**

$V_1$

$V_2$

0

**FIG. 3**

**FIG. 4**

501 — Provide sample in TEM

502 — Select experimental condition

503 — Select parallel illumination

504 — Position sample

505 — Align TEM

506 — Insert phase plate

507 — Check on-plane conditions

508 — Check position of pivot points

509 — Prepare phase plate

510 — Reduce beam current

511 — Locate region-of-interest

512 — Acquire image

**FIG. 5**

Europäisches
Patentamt

European
Patent Office

Office européen
des brevets

# EUROPEAN SEARCH REPORT

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X,D | US 2011/174971 A1 (MALAC MAREK [CA] ET AL) 21 July 2011 (2011-07-21) <br> * abstract; figures * <br> * paragraphs [0002], [0014], [0017] * <br> * paragraphs [0031], [0032], [0035] * <br> * paragraphs [0048], [0051], [0052], [0054], [0055] * <br> * paragraphs [0060], [0061], [0063], [0065], [0070] * <br> ----- | 1-8 | INV. <br> H01J37/26 |
| A | MAJOROVITS ET AL: "Assessing phase contrast electron microscopy with electrostatic Boersch-and Zernike-type phase plates", DISSERTATION,, 26 June 2002 (2002-06-26), page 152pp, XP009136274, <br> * abstract * <br> * pages 25-26 * <br> * page 89 * <br> ----- | 1-8 | |

**TECHNICAL FIELDS SEARCHED (IPC)**

H01J

The present search report has been drawn up for all claims

| Place of search | Date of completion of the search | Examiner |
|---|---|---|
| Munich | 11 September 2013 | Opitz-Coutureau, J |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

                           

& : member of the same patent family, corresponding document

EPO FORM 1503 03.82 (P04C01)

**ANNEX TO THE EUROPEAN SEARCH REPORT
ON EUROPEAN PATENT APPLICATION NO.**

EP 13 16 5356

This annex lists the patent family members relating to the patent documents cited in the above-mentioned European search report.
The members are as contained in the European Patent Office EDP file on
The European Patent Office is in no way liable for these particulars which are merely given for the purpose of information.

11-09-2013

| Patent document cited in search report | Publication date | Patent family member(s) | Publication date |
|---|---|---|---|
| US 2011174971 A1 | 21-07-2011 | JP 2011151019 A<br>US 2011174971 A1 | 04-08-2011<br>21-07-2011 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

•　US 20110174971 A1

**Non-patent literature cited in the description**

•　In-focus phase contrast electron microscopy. **H.M. JOHNSON.** Principles and Techniques of Electron Microscopy, Vol. 3: Biological applications. Electron Optics Laboratory, vol. 3, 174-176

•　**K. NAGAYAMA et al.** Phase Contrast Enhancement with Phase Plates in Biological Electron Microscopy. *Microscopy Today,* July 2010, vol. 18 (4), 10-13